# FASCICULE DE BREVET EUROPEEN

(11) **EP 3 476 015 B1**
(45) Date de publication et mention de la délivrance du brevet: **13.05.2020**
(21) Numéro de dépôt: 17731918.3
(22) Date de dépôt: 23.06.2017
(51) Int. Cl.: H01T 2/02, H01T 1/20

(54) **DISPOSITIF D'AMPLIFICATION DE PUISSANCE**
LEISTUNGSVERSTÄRKER
POWER AMPLIFICATION DEVICE

(30) Priorité: 28.06.2016 FR 1656005
(43) Date de publication de la demande: 01.05.2019
(73) Titulaire: ENE29 S.àr.l., 2453 Luxembourg (LU)
(72) Inventeur: DELCHAMBRE, Michaël, 31100 Toulouse (FR); PECQUOIS, Romain, 31270 Frouzins (FR); INNOCENTI, Nicolas, 31450 Montlaur (FR); GENEZ, David, 31270 Cugnaux (FR)
(74) Mandataire: Argyma
(86) Numéro de dépôt international: PCT/EP2017/065581
(87) Numéro de publication internationale: WO 2018/001905

(56) Documents cités:
- US-A- 5 043 636
- US-A1- 2004 179 317
- US-A1- 2007 165 351

## Description

### Domaine de l'Invention

La présente invention se rapporte au domaine de l'électronique de puissance et concerne plus particulièrement un dispositif d'amplification de puissance. Un tel dispositif trouve notamment son application dans le cadre d'un banc de test de matériaux sous haute pression, d'un banc de test d'une charge ou bien dans le cadre d'une application sismique de fond de puit.

### Etat de la technique

En électronique de puissance, on connaît des dispositifs d'amplification de puissance permettant de transférer en une fraction de seconde un courant de très haute intensité sous très haute tension entre deux électrodes, la tension de polarisation entre les deux électrodes étant fournie par une alimentation externe, comprise par exemple entre 5 et 40 kV.

De tels dispositifs d'amplification de puissance sont en général employés dans des applications telles que le générateur de Marx ou autre montage de très haute tension, par exemple en association avec des condensateurs permettant de stocker l'énergie électrique, et de la restituer sous la forme d'un courant de très haute intensité sous très haute tension. On distingue deux catégories de dispositifs : les dispositifs à gaz et les dispositifs déclenchés.

Un dispositif d'amplification de puissance à gaz se déclenche de manière autonome. A cette fin, un tel dispositif comprend deux électrodes distantes d'un intervalle et disposées en regard l'une de l'autre dans un milieu gazeux ou dans le vide. Un exemple de dispositif d'amplification de puissance à gaz est décrit dans la demande FR2999350A1 déposée par la Demanderesse. Lorsque la tension définie entre les électrodes dépasse une valeur seuil, un arc électrique est créé et le passage du courant est établi. Cette valeur seuil est fonction de la géométrie des électrodes, de la distance entre les électrodes et de la pression du milieu dans lequel sont disposées les électrodes. Un tel dispositif est de conception simple mais présente l'inconvénient de n'être que peu fiable étant donné que dans un milieu gazeux ou dans le vide, la valeur de déclenchement suit en réalité une distribution gaussienne autour de la valeur seuil souhaitée.

Un dispositif d'amplification de puissance déclenché utilise un moyen pour déclencher la génération de l'arc électrique entre deux électrodes principales. Par exemple, un type connu de dispositif d'amplification de puissance déclenché, appelée trigatron, utilise une troisième électrode, appelée électrode de déclenchement, positionnée au voisinage de l'intervalle séparant les deux électrodes principales, par exemple orthogonalement aux deux électrodes principales ou co-axialement à l'une d'elles, pour déclencher la génération de l'arc électrique.

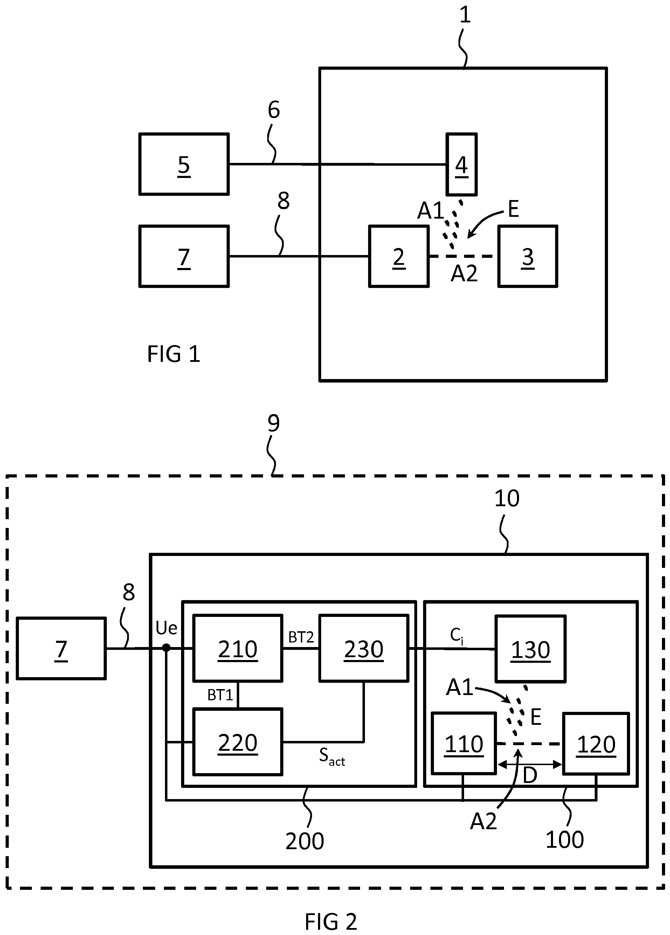

La figure 1 illustre schématiquement un exemple de dispositif d'amplification de puissance déclenché 1 comprenant deux électrodes principales 2 et 3 et une électrode de déclenchement 4. L'électrode de déclenchement 4 est reliée à un générateur de courant 5 externe délivrant une impulsion haute tension (de l'ordre de quelques kV maximum) via un câble 6 l'alimentation « basse tension » tandis que les électrodes principales 2 et 3 sont reliées à un générateur de courant 7 externe délivrant une haute tension (de quelques kV ou dizaines de kV) par un câble 8 d'alimentation « haute tension ». En fonctionnement du dispositif, la tension appliquée à l'électrode de déclenchement 4 permet de créer un canal d'air ionisé A1 dans l'espace E entre les deux électrodes principales 2, 3. Cette ionisation facilite la création d'un deuxième arc électrique A2 (ou arc électrique principal) entre les deux électrodes principales 2, 3, assurant alors le passage du courant. A titre d'exemple, on connaît du document EP0300599 un dispositif d'amplification de puissance comportant deux électrodes principales disposées en regard l'une de l'autre entre lesquelles se développe un arc électrique par l'application d'une tension sur une électrode de déclenchement montée de manière coaxiale à l'intérieur de l'une des deux électrodes principales.

Un dispositif d'amplification de puissance déclenché est significativement plus stable qu'un dispositif d'amplification de puissance à gaz puisqu'il se déclenche toujours à la même valeur de seuil. Toutefois, lorsqu'il est utilisé avec un déclenchement par dépassement d'un seuil d'auto-amorçage, un dispositif d'amplification de puissance déclenché est difficilement réglable, ce qui présente un premier inconvénient. En outre, l'utilisation d'un générateur de courant externe pour délivrer une impulsion à l'électrode de déclenchement présente une limitation importante pour une utilisation embarquée, notamment dans le cas d'un puit de forage dans lequel il est alors nécessaire de faire descendre à la fois le câble d'alimentation de l'électrode de déclenchement en plus du câble d'alimentation haute tension des électrodes principales. De plus, certaines applications telles que le générateur de Marx peuvent nécessiter l'utilisation de nombreux dispositifs d'amplification de puissance déclenchés mis en association, par exemple dans un montage en parallèle, avec de nombreux condensateurs. Il en résulte alors une grande complexité de câblage, notamment pour reprendre l'anode de chaque dispositif d'amplification de puissance vers l'anode des condensateurs voisins, qui s'ajoute aux câblages de l'électrode de déclenchement et des électrodes principales de chaque dispositif d'amplification de puissance déclenché, ce qui présente là encore des inconvénients importants.

US 2004/179317 A1 énonce un dispositif d'amplification de puissance comprenant un module de commutation, ledit module de commutation comprenant une première électrode de déchargement et une deuxième électrode de déchargement, disposées en regard l'une de l'autre à une distance fixe prédéterminée définissant un espace de génération d'un arc électrique, et un moyen de déclenchement situé au voisinage dudit espace et étant configuré pour déclencher la formation dudit arc électrique dans ledit espace.

US 2007/165351 A1 énonce un procédé de génération d'un arc électrique entre une première électrode de déchargement et une deuxième électrode de déchargement, disposées en regard l'une de l'autre à une distance fixe prédéterminée définissant un espace de génération d'un arc électrique, la génération dudit arc électrique étant déclenchée par un moyen de déclenchement situé au voisinage dudit espace, ledit procédé comprenant les étapes de : détection d'un événement d'activation, génération d'un signal d'activation lorsqu'un événement d'activation a été détecté, génération d'une commande impulsionnelle lorsqu'un signal d'activation a été généré, et transmission de ladite commande impulsionnelle générée au moyen de déclenchement afin que le moyen de déclenchement déclenche la formation d'un arc électrique entre la première électrode de déchargement et la deuxième électrode de déchargement.

### Exposé de l'invention

La présente invention a pour but de remédier au moins en partie à ces inconvénients en proposant une solution simple, fiable et efficace de dispositif d'amplification de puissance ne nécessitant pas de câblage externe complexe afin de pouvoir être utilisé dans une application embarquée, par exemple en fond puit pour une application sismique.

À cet effet, l'invention a tout d'abord pour objet un dispositif d'amplification de puissance apte à être alimenté par une unique tension d'entrée et comprenant un module de commutation, ledit module de commutation comprenant une première électrode de déchargement et une deuxième électrode de déchargement, disposées en regard l'une de l'autre à une distance fixe prédéterminée définissant un espace de génération d'un arc électrique, et un moyen de déclenchement situé au voisinage dudit espace et étant configuré pour déclencher la formation dudit arc électrique dans ledit espace, ledit dispositif d'amplification de puissance étant remarquable en ce qu'il comprend un module de déclenchement comprenant un convertisseur de tension configuré pour convertir la tension d'entrée en une première tension d'alimentation et en une deuxième tension d'alimentation, un sous-module de détection configuré pour détecter un évènement d'activation, pour générer, à partir de la première tension d'alimentation, un signal d'activation lorsqu'un évènement d'activation a été détecté, un générateur d'impulsion configuré pour générer, à partir de la deuxième tension d'alimentation, une commande impulsionnelle lorsqu'un signal d'activation a été généré, et pour transmettre la commande impulsionnelle générée au moyen de déclenchement du module de commutation afin que le moyen de déclenchement déclenche la formation d'un arc électrique entre la première électrode de déchargement et la deuxième électrode de déchargement.

La tension d'entrée est une haute tension dont la valeur est supérieure à 1 kV, de préférence comprise entre 5 et 40 kV. Le dispositif d'amplification de puissance selon l'invention est un dispositif auto-déclenché qui fonctionne avec une unique tension d'entrée et donc un seul câble d'alimentation externe, ce qui permet de réduire le nombre de câbles et ne nécessite donc pas de connectique avec l'extérieur pour piloter le moyen de déclenchement ni de batterie additionnelle, son alimentation étant avantageusement pilotée par la deuxième tension. Les dimensions du dispositif d'amplification de puissance selon l'invention peuvent être avantageusement réduites de sorte à être embarqué dans un boitier, par exemple pour le descendre aisément dans un puit de forage. Le module de déclenchement du dispositif selon l'invention peut être utilisé avec la plupart des configurations et types connus d'électrodes de déchargement et de moyen de déclenchement. Le dispositif selon l'invention permet en outre une stabilité et une précision du déclenchement de l'arc électrique indépendamment de la géométrie des électrodes, de la distance entre la première électrode et la deuxième électrode ou de la pression du milieu, ce qui augmente la durée d'utilisation du dispositif d'amplification de puissance sans opération de maintenance.

De préférence, le module de déclenchement comprend un convertisseur de tension, un sous-module de détection et un générateur d'impulsion, le convertisseur de tension étant configuré pour convertir la tension d'entrée en la première tension d'alimentation et en la deuxième tension d'alimentation, le première tension permettant d'alimenter le module de détection, la deuxième tension permettant d'alimenter le générateur d'impulsion.

Dans une première forme de réalisation du dispositif, le module de déclenchement est configuré pour comparer la valeur de la tension d'entrée avec une valeur seuil prédéterminée et générer le signal d'activation lorsque la valeur de la tension d'entrée est supérieure ou égale à la valeur seuil prédéterminée. Dans ce cas, l'utilisation d'un critère de tension pour déclencher l'arc électrique permet de rendre le dispositif indépendant du temps et notamment du temps de charge des condensateurs du générateur de courant lui fournissant la tension d'entrée.

Avantageusement, dans cette première forme de réalisation, le sous-module de détection est configuré pour recevoir la tension d'entrée, comparer la valeur de la tension d'entrée avec une valeur seuil prédéterminée et, lorsque la valeur de la tension d'entrée est supérieure ou égale à la valeur seuil prédéterminée, générer le signal d'activation à partir de la première tension d'alimentation et envoyer ledit signal d'activation au générateur d'impulsion.

De préférence, le délai entre la détection de la valeur seuil prédéterminée par le sous-module de détection et le début du transfert de courant par le moyen de déclenchement est inférieur à 100 µs.

Dans une deuxième forme de réalisation du dispositif, le module de déclenchement comprend une horloge et est configuré pour générer le signal d'activation de manière périodique à partir de ladite horloge.

Avantageusement, dans cette deuxième forme de réalisation, le sous-module de détection comprend l'horloge et est configuré pour générer de manière périodique le signal d'activation à partir de la première tension d'alimentation et pour envoyer ledit signal d'activation au générateur d'impulsion.

De préférence, le moyen de déclenchement se présente sous la forme d'une électrode de déclenchement.

De manière préférée, la valeur de la première tension est comprise entre 1 et 15 V.

Avantageusement, le signal d'activation se présente sous la forme d'un échelon de tension dont l'amplitude est inférieure à 15 V.

De manière avantageuse, la valeur de l'amplitude de l'échelon de tension est égale à la valeur de la première tension.

Avantageusement encore, la valeur de la deuxième tension est de l'ordre de plusieurs centaines de Volts, de préférence de l'ordre de 500 V.

Selon un aspect de l'invention, la commande impulsionnelle se présente sous la forme d'un signal impulsionnel de tension dont la durée est comprise entre 0,5 et 10 µs.

Selon un autre aspect de l'invention, le signal impulsionnel de tension atteint une valeur maximum de l'ordre de 20 kV permettant au moyen de déclenchement de déclencher la formation de l'arc électrique entre la première électrode de déchargement et la deuxième électrode de déchargement.

L'invention concerne aussi un système d'amplification de puissance comprenant un dispositif d'amplification de puissance tel que présenté précédemment et un générateur de courant délivrant une tension de plusieurs kilovolts, de préférence comprise entre 5 et 40 kV, en entrée dudit dispositif d'amplification de puissance.

L'invention concerne aussi un procédé de génération d'un arc électrique entre une première électrode de déchargement et une deuxième électrode de déchargement, disposées en regard l'une de l'autre à une distance fixe prédéterminée définissant un espace de génération d'un arc électrique, la génération dudit arc électrique étant déclenchée par un moyen de déclenchement situé au voisinage dudit espace, ledit procédé, mis en oeuvre par un dispositif d'amplification de puissance alimenté par une tension d'entrée, comprenant les étapes de :
- conversion de la tension d'entrée en une première tension d'alimentation et en une deuxième tension d'alimentation
- détection d'un évènement d'activation,
- génération, à partir de la première tension d'alimentation, d'un signal d'activation lorsqu'un évènement d'activation a été détecté,
- génération, à partir de la deuxième tension d'alimentation, d'une commande impulsionnelle lorsqu'un signal d'activation a été généré, et
- transmission de ladite commande impulsionnelle générée au moyen de déclenchement afin que le moyen de déclenchement déclenche la formation d'un arc électrique entre la première électrode de déchargement et la deuxième électrode de déchargement.

Dans un premier mode de réalisation, le procédé comprend une étape de comparaison de la valeur de la tension d'entrée avec une valeur seuil prédéterminée et le signal d'activation est généré lorsque la valeur de la tension d'entrée est supérieure ou égale à la valeur seuil prédéterminée.

Dans un deuxième mode de réalisation, le module de déclenchement comprenant une horloge, le signal d'activation est généré de manière périodique à partir de ladite horloge.

D'autres caractéristiques et avantages de l'invention apparaîtront lors de la description qui suit faite en regard des figures annexées et données à titre d'exemples non limitatifs et dans lesquelles des références identiques sont données à des objets semblables.

### Brève description des dessins

La figure 1 (déjà commentée) illustre schématiquement un dispositif d'amplification de puissance déclenché de l'art antérieur.
La figure 2 illustre schématiquement une forme de réalisation d'un système d'amplification de puissance selon l'invention.
La figure 3 illustre schématiquement un mode de réalisation du procédé selon l'invention.
La figure 4 est un exemple de signal de tension d'entrée du dispositif d'amplification de puissance de la figure 2.
La figure 5 est un exemple de signal d'activation généré par le module de détection de du dispositif d'amplification de puissance de la figure 2.
La figure 6 est un exemple de commande impulsionnelle générée par le générateur d'impulsion du dispositif d'amplification de puissance de la figure 2.
La figure 7 est un exemple de signal de courant de sortie du dispositif d'amplification de puissance de la figure 2.

### Description détaillée de modes de réalisation de l'invention

Le dispositif d'amplification de puissance selon l'invention est un dispositif de commutation du type commutateur à fermeture comprenant deux électrodes distantes, dites électrodes de déchargement, séparées par un diélectrique (gaz, vapeur, vide...), entre lesquelles se forme un arc électrique lorsque la différence de potentiel entre les électrodes est supérieure à une valeur seuil. Dans un tel dispositif à haute tension, cette valeur seuil est supérieure à quelques kV (kilo Volts), et la tension de fonctionnement du dispositif (tension appliquée au dispositif d'amplification de puissance, c'est-à-dire la différence de potentiel entre ses électrodes), peut aller jusqu'à 1 MV. Un tel dispositif d'amplification de puissance permet de transférer une quantité de charges électriques allant de quelques milli-Coulomb à plusieurs centaines de Coulomb, correspondant à un courant électrique traversant le dispositif d'amplification de puissance d'intensité comprise entre 1 kA et 1 MA. Associé à un générateur de courant, et notamment à un ou plusieurs condensateurs aptes à accumuler les quantités de charges électriques susmentionnées, ce dispositif peut être utilisé pour diverses applications. Le dispositif d'amplification de puissance selon l'invention est un dispositif d'amplification de puissance auto-déclenché qui n'est alimenté que par un unique générateur de courant. A titre d'exemple, le dispositif selon l'invention peut être utilisé pour alimenter de façon séquentielle un banc de test de matériaux sous haute pression ou tout autre charge ou bien dans un puit de forage dans un but sismique, par exemple pour stimuler la production de pétrole. Chaque opération de déchargement du condensateur et de transfert à la charge, par le dispositif d'amplification de puissance, des charges électriques initialement accumulées dans le condensateur, est appelée un tir.

On a représenté à la figure 2 une forme de réalisation d'un système 9 selon l'invention. Ce système 9 comprend un dispositif d'amplification de puissance 10 et un générateur de courant 7 délivrant une unique tension d'entrée Ue au dispositif 10 via un câble d'alimentation haute tension 8.

Le dispositif 10 comprend un module de commutation 100 et un module de déclenchement 200.

Le module de commutation 100 comprend une première électrode 110 de déchargement et une deuxième électrode 120 de déchargement disposées en regard l'une de l'autre à une distance D fixe prédéterminée et définissant un espace E de génération d'un arc électrique A2 à partir de la tension d'entrée Ue. Pour ce faire, le générateur de courant 7 comprend un ou plusieurs condensateurs qui se chargent avec le temps de manière à délivrer une tension Ue croissante pouvant atteindre plusieurs kV, par exemple entre 5 et 40 kV, jusqu'à la formation de l'arc électrique A2 entre la première électrode 110 de déchargement et une deuxième électrode 120 de déchargement comme cela sera expliqué ci-après.

Le module de commutation 100 comprend ensuite un moyen de déclenchement situé au voisinage de l'espace E et qui est configuré pour déclencher la formation d'un arc électrique A2 dans ledit espace E. Dans cet exemple, ce moyen de déclenchement se présente sous la forme d'une troisième électrode, appelée électrode de déclenchement 130. Cette électrode de déclenchement 130 permet de créer un canal d'air ionisé A1 dans l'espace E facilitant la formation de l'arc électrique A2 (appelé arc électrique principal) entre la première électrode de déchargement 110 et la deuxième électrode de déchargement 120 assurant alors le passage du courant.

De manière connue, lors d'un tir, les charges électriques se propagent depuis l'extrémité de connexion de la première électrode de déchargement 110 vers l'extrémité de la deuxième électrode de déchargement 120 à travers l'espace E.

La première électrode de déchargement 110 et la deuxième électrode de déchargement 120 sont de préférence de forme générale cylindriques creuses, symétriques de révolution. De manière connue, la première électrode de déchargement 110 et la deuxième électrode de déchargement 120 sont alignées "bout à bout", c'est-à-dire agencées de sorte que leurs axes longitudinaux respectifs (non représentés) coïncident et qu'elles présentent des extrémités axiales (non représentées), dites extrémités de fermeture, éloignées d'une distance fixe prédéterminée D, par exemple comprise entre 1 et 15 mm environ et en regard selon la direction axiale (direction des axes de symétrie).

L'arc électrique A2 se produit entre ces extrémités axiales de fermeture, dont les faces extrêmes annulaires en regard sont sensiblement planes (dans des plans transversaux). Les extrémités axiales opposées des électrodes, dites extrémités de connexion, sont reliées chacune à un connecteur (non représenté) en vue de l'intégration du dispositif d'amplification de puissance dans un circuit électrique. En particulier, l'un des connecteurs sert au branchement du générateur de courant 7 et l'autre au branchement d'une charge par exemple.

Le module de déclenchement 200 est relié au module de commutation 100 afin de le commander. Le module de déclenchement 200 est configuré pour convertir la tension d'entrée Ue en une première tension d'alimentation BT1 et en une deuxième tension d'alimentation BT2, pour détecter un évènement d'activation et pour générer, à partir de la première tension d'alimentation BT1, un signal d'activation S_{act} lorsqu'un évènement d'activation a été détecté.

A cette fin, dans la forme de réalisation préférée illustrée à la figure 2, le module de déclenchement 200 comprend un convertisseur 210 de tension, un sous-module 220 de détection et un générateur 230 d'impulsion.

Le convertisseur de tension 210 est configuré pour convertir la tension d'entrée Ue fournie par le générateur de courant externe 7 en une première tension d'alimentation BT1 et en une deuxième tension d'alimentation BT2. La première tension d'alimentation BT1, de préférence de l'ordre de quelques Volts (par exemple 5 V), permet d'alimenter le sous-module de détection 220 en énergie électrique. La deuxième tension d'alimentation BT2, de préférence de l'ordre de quelques centaines de Volts (par exemple 500 V), permet d'alimenter le générateur d'impulsion 230 en énergie électrique.

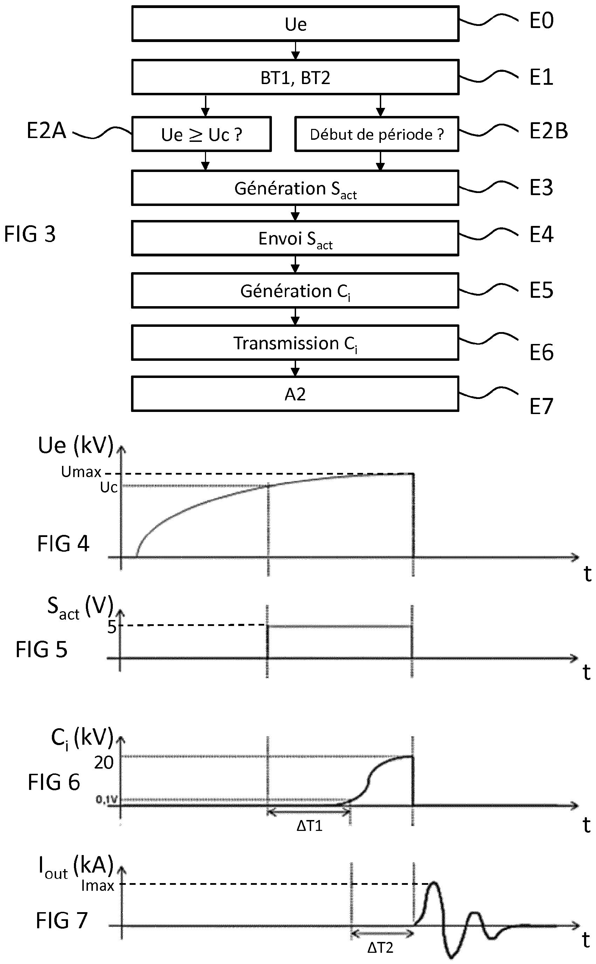

Dans un première forme de réalisation, le sous-module de détection 220 est configuré pour recevoir la tension d'entrée Ue fournie par le générateur de courant 7, pour comparer la valeur de ladite tension d'entrée Ue avec une valeur seuil prédéterminée Uc et, lorsque la valeur de la tension d'entrée Ue est supérieure ou égale à la valeur seuil prédéterminée Uc, pour générer un signal d'activation S_{act} à partir de la première tension d'alimentation BT1 et envoyer ledit signal d'activation S_{act} au générateur d'impulsion 230. Dans ce cas, la détection du dépassement de la valeur seuil prédéterminée Uc par la tension d'entrée Ue constitue l'évènement d'activation. De préférence, en référence à la figure 6, le délai ΔT1 entre la détection de la valeur seuil prédéterminée par le sous-module de détection 220 et le début du transfert de courant par l'électrode de déclenchement 130 est inférieur à 100 µs.

Dans une deuxième forme de réalisation du dispositif, le sous-module de détection 220 comprend une horloge (non représentée) et est configuré pour générer le signal d'activation S_{act} de manière périodique à partir de ladite horloge et pour envoyer ledit signal d'activation S_{act} au générateur d'impulsion 230. Dans ce cas, l'évènement d'activation correspond au début de l'intervalle périodique au cours duquel le signal d'activation S_{act} est généré et envoyé. Une telle horloge étant connue en soi, elle ne sera pas davantage détaillée ici.

Le signal d'activation S_{act} peut être un signal TTL (Transistor-Transistor Logic) connue en soi, correspondant à un échelon de tension dont l'amplitude est égala à la première tension d'alimentation BT1, par exemple 5 V, comme illustré à la figure 5.

Le générateur d'impulsion 230 est configuré pour recevoir un signal d'activation S_{act} du sous-module de détection 220, pour générer une commande impulsionnelle Cᵢ à partir de la deuxième tension d'alimentation BT2 consécutivement à la réception dudit signal d'activation S_{act} et pour transmettre ladite commande impulsionnelle Cᵢ à l'électrode de déclenchement 130 afin de déclencher la génération d'un arc électrique entre la première électrode de déchargement 100 et la deuxième électrode de déchargement 200.

L'invention va maintenant être décrite dans sa mise en oeuvre en référence aux figures 3 à 7.

En référence tout d'abord aux figures 3 et 4, le générateur de courant 7 génère dans une étape E0 un courant qui définit une tension d'entrée Ue du dispositif d'amplification de puissance 10. Cette tension d'entrée Ue est de préférence comprise entre 5 et 40 kV. Cette tension d'entrée Ue, générée par la charge du ou des condensateurs du générateur de courant 7, augmente avec le temps jusqu'à atteindre une valeur maximale Umax pour laquelle un arc électrique A2 se forme entre la première électrode 110 et la deuxième électrode 120 entrainant la décharge des condensateurs du générateur de courant 7 et la chute de la tension d'entrée Ue à zéro.

Dans une étape E1, le convertisseur 210 convertit la tension d'entrée Ue délivrée par le générateur de courant 7, d'une part, en une première tension d'alimentation BT1 du sous-module de détection 220 et, d'autre part, en une deuxième tension d'alimentation BT2 du générateur d'impulsion 230. Dans cet exemple non limitatif, la première tension d'alimentation BT1 est de l'ordre de 5 V et la deuxième tension d'alimentation BT2 est de l'ordre de 500 V.

Toujours en référence aux figures 3 et 4, dans un premier mode de réalisation mettant en oeuvre la première forme de réalisation du dispositif 10 présentée ci-avant, le sous-module de détection 220, qui reçoit aussi la tension d'entrée Ue, compare en permanence, dans une étape E2A, la valeur de ladite tension d'entrée Ue avec une valeur seuil prédéterminée Uc, par exemple de 30 kV. Lorsque la valeur de la tension d'entrée Ue atteint (i.e. égale) la valeur seuil prédéterminée Uc, le sous-module de détection 220 génère, dans une étape E3, un signal d'activation S_{act} à partir de la première tension d'alimentation BT1 et le transmet au générateur d'impulsion 230 dans une étape E4. Comme illustré à la figure 5, ce signal d'activation S_{act} se présente dans cet exemple sous la forme d'un échelon de tension de 5 V, correspondant à la valeur de la première tension d'alimentation BT1.

Dans un deuxième mode de réalisation mettant en oeuvre la deuxième forme de réalisation du dispositif 10 présentée ci-avant, le sous-module de détection 220 détecte le début de l'intervalle de temps périodique généré par l'horloge dans une étape E2B et génère alors de manière périodique le signal d'activation S_{act} dans une étape E3 puis le transmet au générateur d'impulsion 230 dans une étape E4. On notera que dans la deuxième forme de réalisation utilisant une horloge, la tension pour laquelle l'arc électrique se forme peut être définie en adaptant le temps de charge des condensateurs de manière à ce qu'il corresponde à la période de l'horloge.

En référence à la figure 6, lorsqu'il reçoit ce signal d'activation S_{ac}t, le générateur d'impulsion 230 génère à son tour, dans une étape E5, une commande impulsionnelle Ci à partir de la deuxième tension d'alimentation BT2 générée et fournie par le convertisseur 210. Cette commande impulsionnelle est transmise, dans une étape E6, à l'électrode de déclenchement 130.

Dans cet exemple, la commande impulsionnelle Cᵢ se présente sous la forme d'un signal impulsionnelle de tension démarrant au terme du délai ΔT1, le démarrage de ce pic de tension étant détecté lorsque la tension dépasse une valeur seuil minimale. Cette valeur seuil minimale peut être égale à 10 % de la tension maximale, soit par exemple une valeur seuil minimale de 0,1 V. Ce délai ΔT1 correspond au temps écoulé entre la détection du seuil Uc et la génération de l'impulsion de déclenchement Ci. Le signal impulsionnelle croit, pendant un délai ΔT2 compris dans cet exemple entre 0,5 et 10 µs après son démarrage, jusqu'à une valeur maximale de 20 kV.

Pendant cette augmentation de la tension aux bornes de l'électrode de déclenchement 130, un canal d'air ionisé A1 est créé entre la première électrode de déchargement 110 et la deuxième électrode de déchargement 120. Lorsque la tension atteint la valeur seuil prédéterminée ou la fin de la période d'horloge, l'arc électrique principal A2 est généré, dans une étape E7, entre la première électrode de déchargement 110 et la deuxième électrode de déchargement 120.

La tension d'entrée Ue chute alors instantanément à zéro, de même que la valeur de tension du signal d'activation S_{act} (fin de l'échelon de tension) et que la valeur de tension de la commande impulsionnelle Cᵢ. En référence à la figure 7, la formation de l'arc électrique A2 génère un courant de sortir Iₒᵤₜ oscillant dont la valeur peut être comprise dans cet exemple entre 10 et 30 kA.

L'invention permet donc de déclencher un tir en utilisant une électrode de déclenchement 130 sans utiliser d'alimentation de tension externe, l'alimentation du générateur de déclenchement 230 étant réalisée par la deuxième tension BT2 générée par le convertisseur de tension 210. Le dispositif d'amplification de puissance déclenché 10 selon l'invention ne nécessite donc qu'une seule alimentation externe (générateur de courant 7), ce qui réduit le nombre de câbles et permet de l'utiliser aisément dans des endroits d'accès difficile tels que des puits de forage, tout en permettant un déclenchement des tirs à une valeur seuil constante grâce à l'électrode de déclenchement.

Il est à noter que la présente invention n'est pas limitée aux exemples décrits ci-dessus et est susceptible de nombreuses variantes accessibles à l'homme de l'art à partir du moment où elles tombent dans la portée des revendications.

## Revendications

1. Dispositif (10) d'amplification de puissance apte à être alimenté par une unique tension d'entrée et comprenant un module de commutation (100), ledit module de commutation (100) comprenant une première électrode de déchargement (110) et une deuxième électrode de déchargement (120), disposées en regard l'une de l'autre à une distance fixe (D) prédéterminée définissant un espace (E) de génération d'un arc électrique (A2), et un moyen de déclenchement (130) situé au voisinage dudit espace (E) et étant configuré pour déclencher la formation dudit arc électrique (A2) dans ledit espace (E), ledit dispositif d'amplification de puissance (10) étant **caractérisé en ce qu'**il comprend un module de déclenchement (200) comprenant :
- un convertisseur de tension (210) configuré pour convertir la tension d'entrée (Ue) en une première tension (BT1) d'alimentation et en une deuxième tension (BT2) d'alimentation,
- un sous-module de détection (220) configuré pour :
∘ détecter un évènement d'activation,
∘ générer, à partir de la première tension d'alimentation (BT1), un signal d'activation (S_{act}) lorsqu'un évènement d'activation a été détecté,
- un générateur d'impulsion (230) configuré pour :
∘ générer, à partir de la deuxième tension d'alimentation (BT2), une commande impulsionnelle (Cᵢ) lorsqu'un signal d'activation a été généré, et
∘ transmettre la commande impulsionnelle (Cᵢ) générée au moyen de déclenchement (130) du module de commutation (100) afin que le moyen de déclenchement (130) déclenche la formation d'un arc électrique (A2) entre la première électrode de déchargement (110) et la deuxième électrode de déchargement (120).

2. Dispositif d'amplification de puissance (10) selon la revendication 1, **caractérisé en ce que** le module de déclenchement est configuré pour comparer la valeur de la tension d'entrée (Ue) avec une valeur seuil (Uc) prédéterminée et générer le signal d'activation (S_{act}) lorsque la valeur de la tension d'entrée (Ue) est supérieure ou égale à la valeur seuil prédéterminée (Uc).

3. Dispositif d'amplification de puissance (10) selon la revendication 1, **caractérisé en ce que** le module de déclenchement comprend une horloge et est configuré pour générer le signal d'activation (S_{act}) de manière périodique à partir de ladite horloge.

4. Dispositif d'amplification de puissance (10) selon l'une des revendications 1 à 3, **caractérisé en ce que** la valeur de la première tension (BT1) est comprise entre 1 et 10 V.

5. Dispositif d'amplification de puissance (10) selon l'une des revendications 1 à 4, **caractérisé en ce que** le signal d'activation (S_{act}) se présente sous la forme d'un échelon de tension dont l'amplitude est égale à la valeur de la première tension (BT1).

6. Dispositif d'amplification de puissance (10) selon l'une des revendications 1 à 5, **caractérisé en ce que** la valeur de la deuxième tension (BT2) est de l'ordre de plusieurs centaines de Volts.

7. Dispositif d'amplification de puissance (10) selon l'une des revendications 1 à 6, **caractérisé en ce que** la commande impulsionnelle (Cᵢ) se présente sous la forme d'un signal impulsionnel de tension dont la durée est comprise entre 0,5 et 10 µs.

8. Dispositif d'amplification de puissance (10) selon la revendication 7, **caractérisé en ce que** le signal impulsionnel de tension atteint une valeur maximum de l'ordre de 20 kV permettant au moyen de déclenchement (130) de déclencher la formation de l'arc électrique (A2) entre la première électrode de déchargement (110) et la deuxième électrode de déchargement (120).

9. Système (9) d'amplification de puissance (10) comprenant un dispositif d'amplification de puissance (10) selon l'une des revendications précédentes et un générateur de courant (7) délivrant une tension (Ue) comprise entre 5 et 40 kV en entrée dudit dispositif d'amplification de puissance (10).

10. Procédé de génération d'un arc électrique (A2) entre une première électrode de déchargement (110) et une deuxième électrode de déchargement (120), disposées en regard l'une de l'autre à une distance fixe (D) prédéterminée définissant un espace (E) de génération d'un arc électrique, la génération dudit arc électrique (A2) étant déclenchée par un moyen de déclenchement (130) situé au voisinage dudit espace (E), ledit procédé, mis en oeuvre par un dispositif d'amplification de puissance (10) selon la revendication 1 alimenté par une tension d'entrée (Ue), comprenant les étapes de :
- conversion (E1) de la tension d'entrée (Ue) en une première tension (BT1) d'alimentation et en une deuxième tension (BT2) d'alimentation
- détection (E2A, E2B) d'un évènement d'activation,
- génération (E3), à partir de la première tension d'alimentation (BT1), d'un signal d'activation (S_{act}) lorsqu'un évènement d'activation a été détecté,
- génération (E5), à partir de la deuxième tension d'alimentation (BT2), d'une commande impulsionnelle (Cᵢ) lorsqu'un signal d'activation a été généré, et
- transmission (E6) de ladite commande impulsionnelle (Cᵢ) générée au moyen de déclenchement (130) afin que le moyen de déclenchement (130) déclenche la formation d'un arc électrique (A2) entre la première électrode de déchargement (110) et la deuxième électrode de déchargement (120).

## Patentansprüche

1. Leistungsverstärker (10), der imstande ist, von einer einzigen Eingangsspannung versorgt zu werden und ein Schaltmodul (100) umfasst, wobei das Schaltmodul (100) eine erste Entladeelektrode (110) und eine zweite Entladeelektrode (120) umfasst, die in einem vorher festgelegten festen Abstand (D) einander zugewandt angeordnet sind, der einen Raum (E) für das Erzeugen eines Lichtbogens (A2) definiert, und ein Auslösemittel (130), das sich in der Nähe des Raums (E) befindet und konfiguriert ist, um die Bildung des Lichtbogens (A2) in dem Raum (E) auszulösen, wobei der Leistungsverstärker (10) **dadurch gekennzeichnet, dass** er ein Auslösemodul (200) umfasst, umfassend:
- einen Spannungswandler (210), der konfiguriert ist, um die Eingangsspannung (Ue) in eine erste Versorgungsspannung (BT1) und in eine zweite Versorgungsspannung (BT2) zu wandeln,
- ein Detektions-Untermodul (220), das konfiguriert ist, um:
∘ ein Aktivierungsereignis zu ermitteln,
∘ auf der Basis der ersten Versorgungsspannung (BT1) ein Aktivierungssignal (S_{act}) zu generieren, wenn ein Aktivierungsereignis ermittelt wurde,
- einen Impulsgenerator (230), der konfiguriert ist, um:
∘ auf der Basis der zweiten Versorgungsspannung (BT2) einen Impulsbefehl (Cᵢ) zu generieren, wenn ein Aktivierungssignal generiert wurde, und
∘ den generierten Impulsbefehl (Cᵢ) an das Auslösemittel (130) des Schaltmoduls (100) zu übertragen, damit das Auslösemittel (130) die Bildung eines Lichtbogens (A2) zwischen der ersten Entladeelektrode (110) und der zweiten Entladeelektrode (120) auslöst.

2. Leistungsverstärker (10) nach Anspruch 1, **dadurch gekennzeichnet, dass** das Auslösemodul konfiguriert ist, um den Wert der Eingangsspannung (Ue) mit einem vorher festgelegten Grenzwert (Uc) zu vergleichen und das Aktivierungssignal (S_{act}) zu generieren, wenn der Wert der Eingangsspannung (Ue) größer oder gleich dem vorher festgelegten Grenzwert (Uc) ist.

3. Leistungsverstärker (10) nach Anspruch 1, **dadurch gekennzeichnet, dass** das Auslösemodul eine Uhr umfasst und konfiguriert ist, um das Aktivierungssignal (S_{act}) periodisch auf der Basis der Uhr zu generieren.

4. Leistungsverstärker (10) nach einem der Ansprüche 1 bis 3, **dadurch gekennzeichnet, dass** der Wert der ersten Spannung (BT1) zwischen 1 und 10 V liegt.

5. Leistungsverstärker (10) nach einem der Ansprüche 1 bis 4, **dadurch gekennzeichnet, dass** das Aktivierungssignal (S_{act}) in Form einer Spannungsstufe vorliegt, deren Amplitude gleich dem Wert der ersten Spannung (BT1) ist.

6. Leistungsverstärker (10) nach einem der Ansprüche 1 bis 5, **dadurch gekennzeichnet, dass** der Wert der zweiten Spannung (BT2) in der Größenordnung von mehreren Hundert Volt liegt.

7. Leistungsverstärker (10) nach einem der Ansprüche 1 bis 6, **dadurch gekennzeichnet, dass** der Impulsbefehl (Cᵢ) in Form eines Spannungsimpulssignals vorliegt, dessen Dauer zwischen 0,5 und 10 s beträgt.

8. Leistungsverstärker (10) nach Anspruch 7, **dadurch gekennzeichnet, dass** das Spannungsimpulssignal einen maximalen Wert in der Größenordnung von 20 kV erreicht, was es dem Auslösemittel (130) gestattet, die Bildung des Lichtbogens (A2) zwischen der ersten Entladeelektrode (110) und der zweiten Entladeelektrode (120) auszulösen.

9. System (9) zur Leistungsverstärkung (10), umfassend einen Leistungsverstärker (10) nach einem der vorangehenden Ansprüche und einen Stromgenerator (7), der eine Spannung (Ue) zwischen 5 und 40 kV am Eingang des Leistungsverstärkers (10) bereitstellt.

10. Verfahren zum Erzeugen eines Lichtbogens (A2) zwischen einer ersten Entladeelektrode (110) und einer zweiten Entladeelektrode (120), die in einem vorher festgelegten festen Abstand (D) einander zugewandt angeordnet sind, der einen Raum (E) des Erzeugens eines Lichtbogens (A2) definiert, wobei das Erzeugen des Lichtbogens (A2) durch ein Auslösemittel (130) ausgelöst wird, das sich in der Nähe des Raums (E) befindet, wobei das Verfahren von einem Leistungsverstärker (10) nach Anspruch 1 durchgeführt wird, der mit einer Eingangsspannung (Ue) versorgt wird, umfassend die Schritte:
- Umwandeln (E1) der Eingangsspannung (Ue) in eine erste Versorgungsspannung (BT1) und in eine zweite Versorgungsspannung (BT2),
- Ermitteln (E2A, E2B) eines Aktivierungsereignisses,
- Generieren (E3), auf der Basis der ersten Versorgungsspannung (BT1), eines Aktivierungssignals (S_{act}), wenn ein Aktivierungsereignis ermittelt wurde,
- Generieren (E5), auf der Basis der zweiten Versorgungsspannung (BT2), eines Impulsbefehls (Cᵢ), wenn ein Aktivierungssignal generiert wurde, und
- Übertragen (E6) des generierten Impulsbefehls (Cᵢ) an das Auslösemittel (130), damit das Auslösemittel (130) die Bildung eines Lichtbogens (A2) zwischen der ersten Entladeelektrode (110) und der zweiten Entladeelektrode (120) auslöst.

## Claims

1. Power amplification device (10) able to be supplied by a single input voltage and comprising a switch module (100), said switch module (100) comprising a first discharge electrode (110) and a second discharge electrode (120), arranged facing each other at a predetermined fixed distance (D) defining a space (E) for generating an electric arc (A2), and a triggering means (130) situated in the vicinity of said space (E) and being configured to trigger the formation of said electric arc (A2) in said space (E), said power amplification device (10) being **characterised in that** it comprises a triggering module (200) comprising:
- a voltage converter (210) configured to convert the input voltage (Ue) into a first supply voltage (BT1) and into a second supply voltage (BT2),
- a detection sub-module (220) configured to:
∘ detect an activation event,
∘ generate, from the first supply voltage (BT1), an activation signal (S_{act}) when an activation event has been detected,
- a pulse generator (230) configured to:
∘ generate, from the second supply voltage (BT2), a pulse control (Ci) when an activation signal has been generated, and
∘ transmit the generated pulse control (Ci) to the triggering means (130) of the switch module (100) in order that the triggering means (130) trigger the formation of an electric arc (A2) between the first discharge electrode (110) and the second discharge electrode (120).

2. Power amplification device (10) according to claim 1, **characterised in that** the triggering module is configured to compare the value of the input voltage (Ue) with a predetermined threshold value (Uc) and to generate the activation signal (S_{act}) when the value of the input voltage (Ue) is greater than or equal to the predetermined threshold value (Uc).

3. Power amplification device (10) according to claim 1, **characterised in that** the triggering module comprises a clock and is configured to generate the activation signal (S_{act}) periodically from said clock.

4. Power amplification device (10) according to one of claims 1 to 3, **characterised in that** the value of the first voltage (BT1) is comprised between 1 and 10 V.

5. Power amplification device (10) according to one of claims 1 to 4, **characterised in that** the activation signal (S_{act}) is in the form of a voltage step, the amplitude of which is equal to the value of the first voltage (BT1).

6. Power amplification device (10) according to one of claims 1 to 5, **characterised in that** the value of the second voltage (BT2) is of the order of several hundreds of Volts.

7. Power amplification device (10) according to one of claims 1 to 6, **characterised in that** the pulse control (Ci) is in the form of a voltage pulse signal, the duration of which is comprised between 0.5 and 10 ps.

8. Power amplification device (10) according to claim 7, **characterised in that** the voltage pulse signal reaches a maximum value of the order of 20 kV enabling the triggering means (130) to trigger the formation of the electric arc (A2) between the first discharge electrode (110) and the second discharge electrode (120).

9. Power amplification system (9) comprising a power amplification device (10) according to one of the preceding claims and a current generator (7) delivering a voltage (Ue) comprised between 5 and 40 kV at the input of said power amplification device (10).

10. Method for generating an electric arc (A2) between a first discharge electrode (110) and a second discharge electrode (120), arranged facing each other at a predetermined fixed distance (D) defining a space (E) for generating an electric arc, the generation of said electric arc (A2) being triggered by a triggering means (130) situated in the vicinity of said space (E), said method, implemented by a power amplification device (10) according to claim 1 supplied by an input voltage (Ue), comprising the steps of:
- conversion (E1) of the input voltage (Ue) into a first supply voltage (BT1) and into a second supply voltage (BT2)
- detection (E2A, E2B) of an activation event,
- generation (E3), from the first supply voltage (BT1), of an activation signal (S_{act}) when an activation event has been detected,
- generation (E5), from the second supply voltage (BT2), of a pulse control (Ci) when an activation signal has been generated, and
- transmission (E6) of said pulse control (Ci) generated by the triggering means (130) in order that the triggering means (130) trigger the formation of an electric arc (A2) between the first discharge electrode (110) and the second discharge electrode (120).
